# EUROPEAN PATENT SPECIFICATION

(11) **EP 4 390 936 B1**
(45) Date of publication and mention of the grant of the patent: **01.07.2026**
(21) Application number: 23219178.3
(22) Date of filing: 21.12.2023
(51) Int. Cl.: G11C 13/00, H10N 70/20

(54) **MATERIAL STACK FOR MICROELECTRONIC DEVICE, A MICROELECTRONIC DEVICE THAT INTEGRATES SUCH STACK AND METHOD FOR MANUFACTURING SUCH STACK**
MATERIALSTAPEL FÜR MIKROELEKTRONISCHE VORRICHTUNG, MIKROELEKTRONISCHE VORRICHTUNG MIT INTEGRIERTEM SOLCHEN STAPEL UND VERFAHREN ZUR HERSTELLUNG SOLCH EINES STAPELS
EMPILEMENT DE MATÉRIAUX POUR DISPOSITIF MICROÉLECTRONIQUE, DISPOSITIF MICROÉLECTRONIQUE INTÉGRANT UN TEL EMPILEMENT ET PROCÉDÉ DE FABRICATION D'UN TEL EMPILEMENT

(30) Priority: 21.12.2022 EP 22315346
(43) Date of publication of application: 26.06.2024
(73) Proprietor: Commissariat à l'Energie Atomique et aux Energies Alternatives, 75015 Paris (FR)
(72) Inventor: SABBIONE, Chiara, 38054 Grenoble Cedex 09 (FR); NAVARRO, Gabriele, 38054 Grenoble Cedex 09 (FR); TESSAIRE, Magali, 38054 Grenoble Cedex 09 (FR); FREI, Michel Ranjit, Palo Alto, California (US); NISTOR, Lavinia-Elena, 38000 Grenoble (FR)
(74) Representative: Hautier IP

(56) References cited:
- EP-A1- 4 271 166
- US-A1- 2013 270 503
- US-A1- 2022 209 105
- ZHANG Y ET AL: "Characteristics of Si-doped Sb"2Te"3 thin films for phase-change random access memory", APPLIED SURFACE SCIENCE, ELSEVIER, AMSTERDAM , NL, vol. 254, no. 17, 30 June 2008 (2008-06-30), pages 5602 - 5606, XP022680665, ISSN: 0169-4332, [retrieved on 20080312], DOI: 10.1016/J.APSUSC.2008.03.006
- FENG J ET AL: "Si doping in Ge2Sb2Te5 film to reduce the writing current of phase change memory", APPLIED PHYSICS A; MATERIALS SCIENCE & PROCESSING, SPRINGER, BERLIN, DE, vol. 87, no. 1, 1 February 2007 (2007-02-01), pages 57 - 62, XP019490441, ISSN: 1432-0630, DOI: 10.1007/S00339-006-3851-2

## Description

### TECHNICAL FIELD

The present invention relates to at least one material stack for microelectronic device, a microelectronic device that integrates such stack and a method for manufacturing such stack.

A non-limitative application of this invention relates to a stack for Phase-Change Memory (PCM) device.

The present invention may relate to Phase-Change Memory (PCM) technology, and more particularly to a material stack for Phase-Change Memory (PCM) device. The PCM technology is now a reality on the market, thanks to Optane^{™} product of Intel^{®}, which targets "Storage Class Memory" applications.

Today, developments concerning the new generation PCM focus on improving the performance of the cell in order to:
a. Reduce the programming current;
b. Increase the reliability (i.e. better endurance, higher speed, long and high temperature data retention, etc.);
c. Reduce the electrical parameters variability and increase the yield.

Other applications of the present invention are related to photonics or RF (Radio Frequency) switches.

### PRIOR ART

In the last years, a lot of attention has been given to the concept of "Interfacial Phase-Change Memory" or "iPCM", based on the superposition of chalcogenide crystalline layers deposited at high temperature, in a super-lattice-layers (SLLs) configuration of the material stack integrated in the device. This structuration of the deposited active PCM stack is in opposition with the classical "bulk" approach according to which the layer is deposited by PVD technique at low temperature and in the amorphous phase. The main perspective behind such SLLs is the potential advantages that they could give in terms of current reduction thanks to the enhanced thermal properties of the stack or even new physical mechanisms involved in the resistance commutation of these devices.

Moreover, the high degree of crystallinity (i.e. high texturing) of the chalcogenide layer obtained by SLL approach, can give a higher control of the stability of said layer along the fabrication steps owing to the Back-End-of-Line (BEOL) of the integration (i.e. up to more than 400°C). By opposition to the "iPCM" approach, and according to the bulk approach, an amorphous layer can trigger the crystallization during the fabrication, leading to the completely random and uncontrolled formation of crystallites and even to segregation phenomena; such formation of crystallites and segregation phenomena could represent a dangerous source of defectivity in the final memory array, or even a source of variability in the electrical answer of the memory device since the beginning of the life of the product.

Even if the SLL is based on crystalline layers, the layers that are integrated in the stack generally face an intermixing once exposed to high temperature, but the grains generally arrange along a preferential orientation parallel to the substrate surface. It is the case of the original proposed iPCM stack based on the sequence of GeTe and Sb₂Te₃ layers. Recently, the intermixing problem of this stack has been addressed with the proposal to introduce some "stabilizing" elements in the GeTe layer (See "Intermixing suppression through the interface in GeTe/Sb2Te3 superlattice" of Tominaga et al., Applied Physics Express, Volume 13, 075503 (2020)). The idea is more particularly to reduce the Ge diffusivity by introducing an element that reacts with Ge and not with Te, and it could be found in S (sulfur) or Se (selenium). Being Ge-S bonds stronger than Ge-Se, the S dopant was investigated. However, the introduction of S in the layer was not considered from an electrical and device point of view, since the S doping could increase the resistivity of the layer and change the electrical properties and the final performances of the memory device.

Otherwise, the Si-doping has been investigated in the past in order to reduce the programming current of standard bulk PCM devices (See "Si doping in Ge2Sb2Te5 film to reduce the writing current of phase change memory" of Feng et al., Applied Physics A, volume 87, pages 57-62 (2007)). It could be also responsible for a better thermal stability of the amorphous phase, introducing a higher disorder in the layer. However, once the device programmed in the SET state (crystalline), it could give rise to a Si precipitation, dependently on its content (See: i) "Silicon doping effect on the crystallization behavior of Ge2Sb2Te5 film" of Jiang et al., Physica Status Solidi (A), 210 (10), 2231-2237 (2013); ii) "Effect of Si doping on the structure and optical properties of Ge2Sb2Te5 studied by ab initio calculations" of Yang et al., Computational Materials Science, Volume 168, Pages 253-259, 2019; iii) "Characteristics of Si-doped Sb2Te3 thin films for phase-change random access memory" of Zhang et al., Applied Surface Science, vol. 254, p. 5602-5606, 2008).

If the benefits of Si doping are clear from literature reports, the possibility to dope a SLL structure with Si dopant is unknown. It raises the question on how it could be possible to incorporate such element in SLL (e.g. US 2013/0270503 A1) without perturbing the quality of the layer and its SLL structure, and more generally on how to obtain a crystalline textured layer with silicon (Si) doping. The main challenge would be to create, during deposition, a structure in which the Si is embedded inside the crystalline matrix with the following pursued advantages:
a. Stabilize the structure thanks to the formation of Si-Te bonds and retard the layer possible reorganization (i.e. intermixing) that could happen during the BEOL of the chip fabrication and/or during the memory device programming/reading operations. However, even if a reorganization takes place, it should go in the direction of an "even more stable" crystalline structure doped with Si (i.e. without Si precipitation); and /or
b. Likely reduce the thermal conductivity of the layer (linked to the electrical conductivity), in particular of the out-of-plane one, for an improved thermal efficiency of the memory device (i.e. lower programming current).

More generally, there exists a need for a crystalline textured layer with silicon (Si) doping showing satisfying stability and/or reduced thermal conductivity, and for a method of manufacturing the same.

### SUMMARY

To achieve this objective, a first aspect of the invention relates to a material stack for microelectronic device, such as Phase-Change Memory (PCM) device, comprising:
a. A substrate,
b. A first undoped monocrystalline layer on the substrate, said first undoped monocrystalline layer having a thickness superior or equal to 4 nm, and
c. A Si-doped crystalline chalcogenide layer on the first undoped monocrystalline layer, said Si-doped crystalline chalcogenide layer being doped with Si having an atomic concentration ranging from 0.5 at.% to 20 at.%, and preferably from 2 at.% to 12 at.%, and said Si-doped crystalline chalcogenide layer having a thickness comprised in between 0.5 nm and 20 nm.

The first undoped monocrystalline layer acts as a buffer layer of the Si-doped crystalline chalcogenide layer with respect to the form (crystalline, polycristalline or even amorphous) of the substrate. Moreover, the superior limit of the at. % of Si for the Si-doped crystalline chalcogenide layer allows to avoid Si precipitation during the deposition itself and the manufacturing of said microelectronic device which are subsequent to the manufacturing of said material stack, said manufacturing comprising for instance an integration process possibly implying a thermal treatment of the material, if needed for manufacturing said microelectronic device.

A second aspect outside the scope of the present invention relates to a thermally processed material stack for microelectronic device, such as a Phase-Change Memory (PCM) device, comprising:
a. A substrate, and
b. A thermally processed Si-doped crystalline chalcogenide layer on the substrate, said thermally processed Si-doped crystalline chalcogenide layer being doped with less than 20 at.%, and preferably less than 12 at.%, of Si and said thermally processed Si-doped crystalline chalcogenide layer having a crystal surface parallel to the substrate equal to or greater than 400 nm², preferably equal to or greater than 20 nm x 20 nm.

The second aspect is provided by a thermal step performed on the material stack according to the first aspect of the invention. More particularly, the thermal step performed on the material stack according to the first aspect of the invention may solely allow manufacturing said thermally processed material stack according to the second aspect.

Each provided material stack, either thermally processed or not, shows a satisfying stability thanks to the Si dopants, and more particularly to the likely formation of Si-Te bonds, that contribute to retard, or even avoid, the layer possible reorganization (i.e. intermixing) that could happen during the manufacturing of said material stack, as well as during the manufacturing of said microelectronic device which is subsequent to the manufacturing of said material stack, such as the BEOL manufacturing steps of the microelectronic device.

In case said microelectronic device is a memory device, the provided material stack, either thermally processed or not, also shows a satisfying stability during the memory device programming/reading operations.

Owing to this stability, even if a reorganization takes place, it should go in the direction of an "even more stable" crystalline structure of the material stack, either thermally processed or not, and more particularly of the Si-doped crystalline chalcogenide layer, either thermally processed or not.

Otherwise, the provided material stack, either thermally processed or not, allows reducing the thermal conductivity of the crystalline chalcogenide layer (linked to the electrical conductivity), in particular of the out-of-plane one, for an improved thermal efficiency of the microelectronic device. In the framework of memory devices, this reduction of thermal conductivity induces the possibility to use a lower programming current.

The challenge as enunciated above is thus fulfilled.

A third aspect outside the scope of the present invention relates to a method for manufacturing a material stack according to the first aspect of the invention, the manufacturing method comprising:
a. Providing a substrate,
b. Depositing, on the substrate, a first undoped crystalline layer having a thickness superior to 4 nm, and
c. Depositing, by sputtering or co-sputtering at a temperature comprised in between 150 and 300°C, on the first undoped crystalline layer, a Si-doped crystalline chalcogenide layer doped with less than 20 at.%, and preferably less than 12 at.%, of Si and having a thickness equal to or less than 20 nm.

A fourth aspect of the invention relates to a method for manufacturing a thermally processed material stack according to the second aspect, the manufacturing method comprising:
a. A step of providing a material stack according to the first aspect of the invention, and
b. A step of thermal treatment of the provided material stack. Said step of thermal treatment can be part of an integration process of the provided material stack in a microelectronic device.

A fifth aspect of the invention relates to a microelectronic device, such as a Phase-Change Memory (PCM) device, comprising at least a material stack according to the first aspect of the invention or at least a thermally processed material stack according to the fourth aspect of the invention further comprising a top electrode of the microelectronic device on the material stack, and wherein a substrate of the concerned material stack comprises a bottom electrode of the microelectronic device.

A sixth aspect relates to a memory array comprising a Phase-Change Memory (PCM) device according to the fifth aspect of the invention.

### BRIEF DESCRIPTION OF THE FIGURES

The aims, objects, as well as the features and advantages of the invention will appear better from the detailed description of an embodiment of the latter which is illustrated by the following appended drawings wherein:
In the legend of the figure, the Si doping is represented by the annotation ":Si " (i.e. Ge₂Sb₂Te₅:Si). The undoped crystalline chalcogenide layer acts as a buffer layer and it can also be defined as under-layer (or UL).
Figure 1 is a graph showing the result of a XRD omega scan for (009) peak of crystalline Sb₂Te₃ layers with Si doping at 12 at. % (curve with long dashes and dots) and without Si doping (curve with dashes) deposited on native silicon oxide of a silicon wafer substrate.
Figure 2 is a graph showing the result of XRD spectra for a multi-layers (ML) based on Ge₂Sb₂Te₅ and Sb₂Te₃ doped with 12 at. % of Si; the ML without UL (curve with long dashes and dots) shows a very poor crystallinity (i.e. with no texture) whereas the ML with UL (curve with dashes) shows a crystallinity (i.e. a texture).
Figure 3 is a graph showing the result of a XRD omega scan at 2Theta=25.5°of a ML with Ge₂Sb₂Te₅:Si thickness of 3.6 nm alternate with Sb2Te3 thickness of 2 nm on Sb2Te3 buffer layer (6.3nm).
Figure 4 is a graph showing the result of a XRD omega scan at 2Theta=25.5° of a ML with Ge₂Sb₂Te₅:Si12% with a thickness of 1.8 nm (top curve) or 3.6 nm (bottom curve) alternates with Sb2Te3 (1 nm and 2 nm) on Sb2Te3 buffer (6.3 nm).
Figure 5 is a graph showing the result of a XRD omega scan at 2Theta=25.5° of a ML with Ge₂Sb₂Te₅:Si12% with a thickness of 3.6 nm alternates with Sb2Te3 2 nm or 6 nm on Sb2Te3 buffer (6.3 nm).
Figure 6 is a TEM image of a ML made by alternation of Ge₂Sb₂Te₅:Si8% (3.6nm) and Sb₂Te₃ (2.1nm) over a buffer layer Sb₂Te₃ (6.3nm). The total ML thickness is about 50 nm.
Figure 7 is a TEM image of a ML made by alternation of Sb₂Te₃:Si12% (2.1 nm) Ge₂Sb₂Te₅ (3.6 nm) and over a buffer consisting in a bilayer made of Sb₂Te₃ (6.3 nm) and Ge₂Sb₂Te₅ (3.6 nm). The total ML thickness is around 50 nm.
Figure 8 is a TEM image of a ML Sb₂Te₃:Si12% (2.1 nm) Ge₂Sb₂Te₅ (3.6 nm) and over a buffer layer Sb₂Te₃ (6.3 nm). Figure 8 shows magnification of the crystalline structure.
Figure 9 is a graph showing the result of a XRD omega scan at 2Theta=25.5° of a ML with Sb₂Te₃:Si12% with a thickness of 2.1 nm alternates with Ge₂Sb₂Te₅ 3.6 nm on Sb₂Te₃ buffer (6.3 nm) as deposited and after annealing at 400°C for 15 minutes.
Figure 10 is a graph showing the result of a XRD 2Theta-Theta scan of a ML with Sb₂Te₃:Si12% with a thickness of 2.1 nm alternates with Ge₂Sb₂Te₅ 3.6 nm on Sb₂Te₃ buffer (6.3 nm) as deposited and after annealing at 400°C for 15 minutes.
Figure 11 is a TEM image of a ML with Sb₂Te₃:Si12% with a thickness of 2.1 nm alternated with Ge₂Sb₂Te₅ 3.6 nm on Sb₂Te₃ buffer (6.3 nm) after annealing at 400°C for 15 minutes.
Figure 12 is an EDX image of a ML with Sb₂Te₃:Si12% with a thickness of 2.1 nm alternated with Ge₂Sb₂Te₅ 3.6 nm on Sb₂Te₃ buffer (6.3 nm) after annealing at 400°C for 15 minutes. A uniform distribution of all the elements is observed.
Figure 13 is a TEM image of a ML made by alternation of Ge₂Sb₂Te₅:Si8% (3.6 nm) and Sb₂Te₃ (2.1 nm) over a buffer layer Sb₂Te₃ (6.3 nm) after annealing at 400°C for 15 minutes. The arrows indicate the presence of 3-tuple, with the appearing of the new feature.
Figure 14 is a TEM image at higher resolution of a ML made by alternation of Ge₂Sb₂Te₅:Si8% (3.6 nm) and Sb₂Te₃ (2.1 nm) over a buffer layer Sb₂Te₃ (6.3 nm) after annealing at 400°C for 15 minutes. This image shows detail of the new appeared feature.
Figure 15 is a TEM image of a GeSb₂Te₄ layer deposited at 225°C without UL doped with 5 at. % of Si after annealing at 400°C; The texture of the layer is impossible to achieve.
Figure 16 is a first example of a material stack according to the invention in between top and bottom electrodes for a PCM device.
Figure 17A is a second example of a material stack according to the invention in between top and bottom electrodes; More particularly, said second example comprises, over the UL, a bilayer where the PCM material is a chalcogenide crystalline layer.
Figure 17B is a variant of the second example illustrated on figure 17A wherein two or more bilayers can be used and repeated *n* times.
Figure 18A is a third example of a material stack according to the invention in between top and bottom electrodes; More particularly, said third example comprises a crystalline Si-doped PCM layer over the UL, followed by a bilayer consisting in a undoped layer of PCM material and a second crystalline Si-doped PCM layer with different Si content or chalcogenide composition.
Figure 18B is a variant of the third example illustrated on figure 18A wherein two or more bilayers can be used and repeated *n* times which are based on the same material as the UL or on different ones.

The drawings are provided as examples and do not limit the invention. They form schematic principle representations intended to facilitate the understanding of the invention and are not necessarily to the scale of the practical applications. In particular, the thicknesses of the different illustrated layers are not necessarily representative of reality or of realistic shape factors.

### DETAILED DESCRIPTION

Before starting a detailed review of embodiments of the invention, optional features that could possibly be used in combination or alternatively are set out hereinafter.

As an example of the first aspect of the invention, each undoped crystalline layer may be based on a material allowing its heterogenous epitaxial growth on the substrate and allowing the heterogenous epitaxial growth of the Si-doped crystalline chalcogenide layer thereon.

As another example of the first aspect of the invention, said first undoped monocrystalline layer has a crystalline orientation along the (001) planes.

As another example of the first aspect of the invention, said undoped monocrystalline layer may have a stoichiometric composition allowing a deviation of plus or minus 2 at. %, preferably 1 at. %, from a targeted stoichiometric composition, preferably from a perfect one.

As another example of the first aspect of the invention, said undoped monocrystalline layer may be an undoped monocrystalline chalcogenide layer, preferably this latter being a chalcogenide material different or same from the one of said Si-doped crystalline chalcogenide layer.

As another example of the first aspect of the invention, the material stack may further comprise:
a. A second undoped crystalline layer over said Si-doped crystalline chalcogenide layer, with said second undoped crystalline layer having a thickness comprised in between 1 and 20 nm and being preferably based on a chalcogenide material, and
b. A secondary Si-doped crystalline chalcogenide layer over said second undoped crystalline layer, with said secondary Si-doped crystalline chalcogenide layer being based on the same chalcogenide material than said Si-doped crystalline chalcogenide layer.

As an alternative example of the first aspect of the invention with respect to the preceding one, the material stack may further comprise:
a. a second undoped crystalline layer over said Si-doped crystalline chalcogenide layer, with said second undoped crystalline layer having a thickness comprised in between 1 and 20 nm and being preferably based on a chalcogenide material, and
b. at least one sub-stack over said second undoped crystalline layer, each sub-stack comprising:
   i. A secondary Si-doped crystalline chalcogenide layer, and
   ii. A secondary undoped crystalline layer over said secondary Si-doped crystalline chalcogenide layer,
with each secondary Si-doped crystalline chalcogenide layer being based on the same chalcogenide material than said Si-doped crystalline chalcogenide layer.

As an alternative example of the first aspect of the invention with respect to the two preceding ones, the material stack may further comprise:
a. A second undoped crystalline layer over said Si-doped crystalline chalcogenide layer, with said second undoped crystalline layer having a thickness comprised in between 1 and 20 nm and being preferably based on a chalcogenide material, and
b. a secondary Si-doped crystalline chalcogenide layer over said second undoped crystalline layer, with said secondary Si-doped crystalline chalcogenide layer being based on a different chalcogenide material than the one of said Si-doped crystalline chalcogenide layer and/or having a different concentration of Si dopants than the one of said Si-doped crystalline chalcogenide layer.

As an alternative example of the first aspect of the invention with respect to the three preceding ones, the material stack may further comprise:
a. a second undoped crystalline layer over said Si-doped crystalline chalcogenide layer, with said second undoped crystalline layer having a thickness comprised in between 1 and 20 nm and being preferably based on a chalcogenide material, and
b. at least one sub-stack over said second undoped crystalline layer, each sub-stack comprising:
   i. A secondary Si-doped crystalline chalcogenide layer, and
   ii. A secondary undoped crystalline layer over said secondary Si-doped crystalline chalcogenide layer,
with at least one secondary Si-doped crystalline chalcogenide layer being based on a different chalcogenide material than the one of said Si-doped crystalline chalcogenide layer and/or having a different concentration of Si dopants than the one of said Si-doped crystalline chalcogenide layer.

As a further example of the first aspect of the invention and in relation with the three preceding ones, the material stack may further comprise more than one sub-stack. The sub-stacks are preferably subsequently and directly stacked on each other. More particularly, several sub-stacks are stacked on each other until a total thickness of at least 20 nm, preferably 50 nm or more, of the material stack is reached.

As another example of the first aspect of the invention, said first undoped monocrystalline layer extending on the substrate may have a thickness comprised in between 4 and 20 nm, preferably in between 4 and 10 nm.

As another example of the first aspect of the invention, each Si-doped crystalline chalcogenide layer and/or each undoped monocrystalline chalcogenide layer may be based on a material chosen among:
a. GeₓSb_{y}Te_{z} (GST) where "x-y-z" are chosen to reach a stoichiometric composition (such as "2-2-5", "1-2-4", "1-4-7"; etc.) allowing a deviation of plus or minus 2 at. %, preferably 1 at. %, from a targeted stoichiometric composition, preferably from a perfect one,
b. GeTe, and
c. Sb₂Te₃.

As another example of the first aspect of the invention, the first undoped monocrystalline layer extending on the substrate may be based on at least one material chosen among:
a. Sb₂Te₃,
b. Bi₂Te₃, and
c. Sb₂Se₃.

As another example of the first aspect of the invention, said Si-doped crystalline chalcogenide layer is doped with Si having an atomic concentration ranging from 0.5 to 20 at. %, and preferably from 2 to 18 at. %, and even more preferably from 2 to 12 at. %.

As another example of the first aspect of the invention, each Si-doped crystalline chalcogenide layer has a thickness comprised in between 0,5 and 20 nm, preferably in between 1 and 6 nm.

As another example of the first aspect of the invention, said Si-doped crystalline chalcogenide layer may extend directly on the first undoped monocrystalline layer.

As another example of the first aspect of the invention, the substrate comprises a heater, and the first undoped monocrystalline layer is over the heater.

As an example of the second aspect, said thermally processed Si-doped crystalline chalcogenide layer may have a thickness comprised in between 5 and 100 nm, preferably in between 10 and 100 nm, and even more preferably in between 20 and 80 nm, typically equal to 50 nm.

As an example of the third aspect, the step of providing a material stack may comprise at least:
a. Providing the substrate,
b. Depositing, on the substrate, a first undoped crystalline layer having a thickness superior to 4 nm, and
c. Depositing, by sputtering or co-sputtering at a temperature comprised in between 150 and 300°C, on the first undoped crystalline layer, a Si-doped crystalline chalcogenide layer doped with less than 20 at.%, and preferably less than 12 at.%, of Si and having a thickness equal to or less than 20 nm.

More generally, the step of providing a material stack may comprise anyone of the steps of the method for manufacturing a material stack according to the first aspect of the invention.

As an example of the fourth aspect of the invention, the step of thermal treatment is performed at a temperature comprised in between 200 and 500°C, preferably in between 300 and 400°C.

As an example of the fourth aspect of the invention, said step of thermal treatment is part of an integration process of the material stack in a microelectronic device.

As an example of the fourth aspect of the invention, said step of thermal treatment is such that, once thermally processed, said Si-doped crystalline chalcogenide layer has a crystal surface parallel to the substrate equal to or greater than 400 nm², preferably equal to or greater than 20 nm x 20 nm. The crystal orientation allows a deviation of less than 10° with respect to the substrate.

As an example of the fourth aspect of the invention, said provided material stack comprises a substrate and a multilayer extending on the substrate, said multilayer comprising a plurality of Si-doped crystalline chalcogenide layers and undoped monocrystalline chalcogenide layers and having a global thickness comprised in between 5 and 100 nm, preferably in between 10 and 100 nm, and even more preferably in between 20 and 80 nm, typically equal to 50 nm.

A layer or film based on a material A is understood to mean a film comprising this material A and possibly other materials.

A crystalline material, or layer, is a solid material, or layer, whose constituents (such as atoms, molecules, or ions) are arranged in a highly ordered microscopic structure, forming a crystal lattice that extends in all directions. A crystalline material, or layer, thus distinguishes from an amorphous material, or layer, and from a polycrystalline material, or layer. All through the present application, word "crystalline" for specifying a material or a layer may mean "formed of crystals having a specific size equal to or greater than 20 nm in x and y directions (parallel to the substrate surface), if needed notably for better distinguishing said crystalline material, or layer, from said polycrystalline material, or layer. Otherwise, the term "textured" is used to qualify a material exhibiting a crystalline arrangement along a specific direction.

In the context of the present invention, the first undoped layer is monocrystalline.

Epitaxy is a well-known phenomenon of material growth. It is common in minerals which often exhibit special orientation relationships of their lattices. Heteroepitaxy or heterogenous epitaxy is a special case of heterogeneous nucleation in which a distinct crystallographic relationship exists between the orientations of the material of the under layer and the material which is deposited on it. Thus, heteroepitaxy refers to the heterogeneous epitaxial growth of a deposit on an (under)layer of a different material and the formation of bonds at the surfaces between the two materials. A specific type of heteroepitaxy is the Van der Waals epitaxy that refers to the growth mechanism in which the layers are bond together via van der Waals-type weak interactions. This results in far small lattice-mismatch distortion in the grown film even if it has a different lattice constant. In the following, we will refer to heteroepitaxy for the van der Waals type growth.

By a "chalcogenide" layer is meant a layer made of a material based on chemical elements in group 16 of the periodic table, and more particularly based on at least one of the following chemical elements: sulfur (S), selenium (Se) and tellurium (Te).

When a sub-stack or a layer is extending or stacked "directly" onto another sub-stack or layer, it means that there is no intermediate layer or sub-stack therebetween.

The detailed description below is concerned by a material stack 10 for a Phase-Change Memory (PCM) device 1 as illustrative embodiment only, since the material stack 10 according to the first aspect of the invention may alternatively be dedicated to different kinds of microelectronic devices 1 as well, and notably to photonics or RF switches microelectronic devices.

We discuss below the set of conditions for growing a crystalline chalcogenide phase-change material doped with silicon.

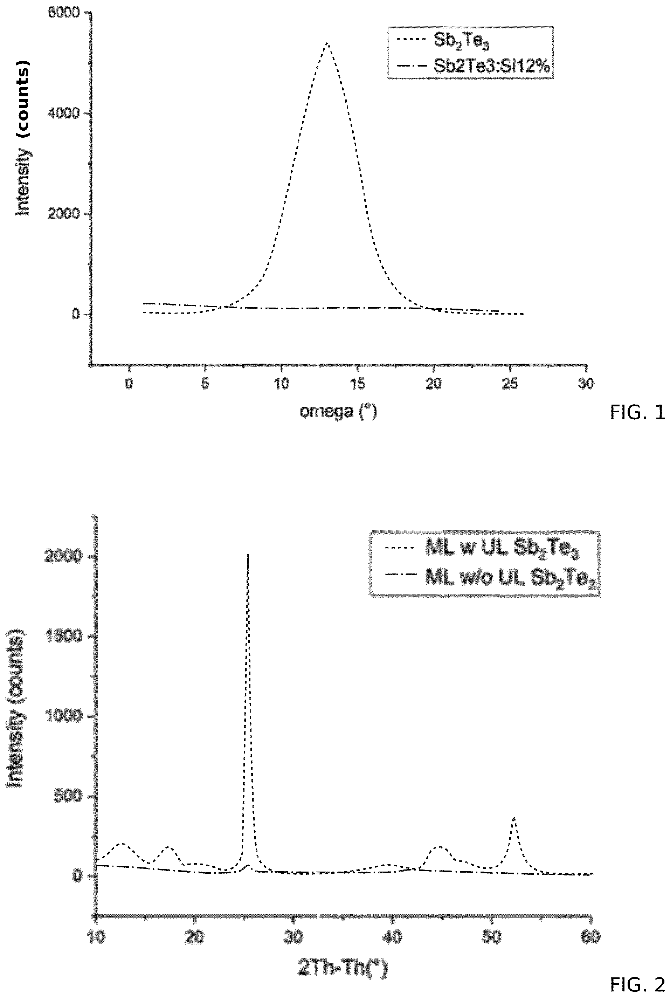

The silicon doping is a source of disorder in the crystalline PCM, as highlighted above, so that the adding of a doping to a chalcogenide material such as Sb₂Te₃ layer could likely perturb its crystalline arrangement, giving rise to a polycristalline material with short range order (below 10 nm), as known from literature and confirmed by the inventor's experiment illustrated on Figure 1 showing that Si doping induces high disorder during deposition, leading to the loss of the high texture along the 00I direction.

A big challenge is to make these layers keeping their crystalline arrangement after a BEOL thermal budget (i.e. at 400°C).

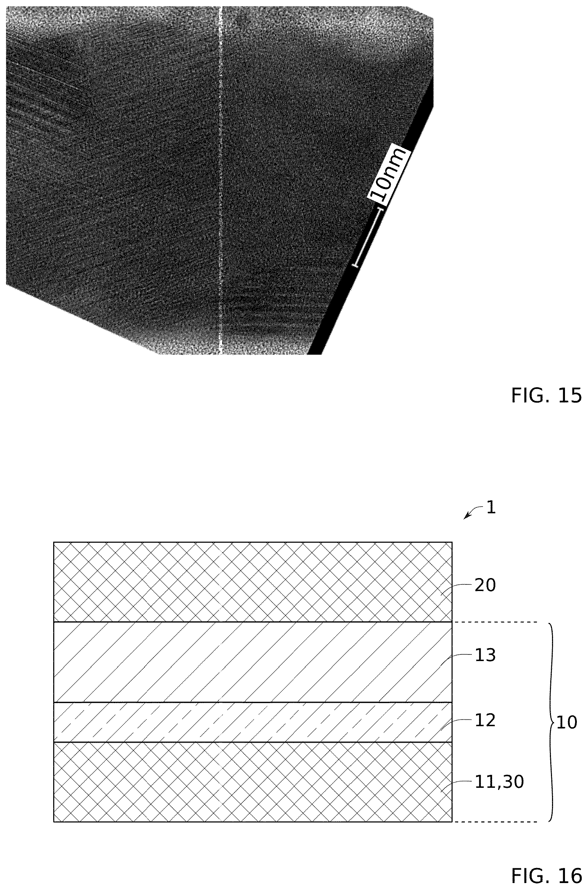

For achieving this purpose, and by reference to Figures 16 to 18B, the use of a first undoped monocrystalline layer 12, as a buffer layer or equivalently as an under-layer (UL), is provided. Said first undoped monocrystalline layer 12 has a thickness of few nm (≥ 4 nm) and may be based on a chalcogenide material, such as (but not limited to) Sb₂Te₃, which shows crystalline arrangement along (001) planes. The deposition of the first undoped monocrystalline layer 12 may be done at a deposition temperature in the range 150°C ≤ T ≤ 300°C. This is a typical range for PVD (physical vapor deposition) process, but the first undoped monocrystalline layer 12 (also called hereafter "under-layer" or "UL") can be deposited with whatever other technique, with the condition to achieve a stoichiometry and crystalline arrangement. For instance, CVD (chemical vapor deposition), ALD (atomic layer deposition), IBD (ion beam deposition), PLD (pulsed laser deposition), MBE (molecular-beam epitaxy), etc. are possible deposition techniques.

A minimal crystalline arrangement degree is greatly preferred to ensure the growth of a Si-doped crystalline chalcogenide layer 13 on the under-layer 12.

Others chalcogenide materials can be used for the under-layer 12 such as Bi₂Te₃, Sb₂Se₃, etc.

On the top of the under-layer 12, it is possible to deposit a chalcogenide layer which has the same crystalline orientation as the under-layer. The crystalline orientation of the under-layer 12 is preferably along the (001) planes. The introduction of a dopant in the grown chalcogenide layer, could affect the right growth of the chalcogenide layer, therefore a set of specific precautions should be adopted.

It is possible to dope with silicon (Si) most of the chalcogenide materials used for PCM fabrication, such as (but not limited to) GeₓSb_{y}Te_{z} (where "x-y-z" are favorably chosen to reach stoichiometric compositions such as "2-2-5", "1-2-4", "1-4-7" etc.), GeTe, Sb₂Te₃, etc.

The deposition of the Si-doped crystalline chalcogenide layer 13 has to be done at a temperature at which the layer material is deposited under its crystalline form that is at a temperature approximately equal to 225°C, typically at a deposition temperature comprised in between 150 and 300°C.

The crystalline arrangement of the Si-doped crystalline chalcogenide layer 13 does not depend on the material of the substrate 11 on which the deposition is done, as long as the under-layer 12 can accommodate the ordered crystalline orientation. The presence of the under-layer 12 is mandatory to obtain the Si-doped crystalline chalcogenide layer 13 which has a satisfying crystalline arrangement.

Note here that, in case of PCM fabrication, the deposition of said under-layer 12 and said Si-doped crystalline chalcogenide layer 13 is generally done on a substrate 11 having a heterogeneous surface composed by metals such as TiN, W, TaN, etc. and dielectrics such as SiO₂, SiN, SiC, etc. The largest area on which said under-layer 12 and said Si-doped crystalline chalcogenide layer 13 are deposited may thus be based on an amorphous dielectric material such as SiN or SiO₂.

The Si-doped crystalline chalcogenide layer 13 thus deposited has a high crystalline arrangement close to the one of the under-layer 12.

It could be that, moving far from the under-layer 12 along the z direction (perpendicular to the plan of main extension of each layer of the material stack 10), the Si-doped crystalline chalcogenide layer 13 will stay crystalline but with a more and more degraded crystalline arrangement, or even a polycrystalline arrangement, if the thickness of the layer 13 is grown to be superior to 20 nm.

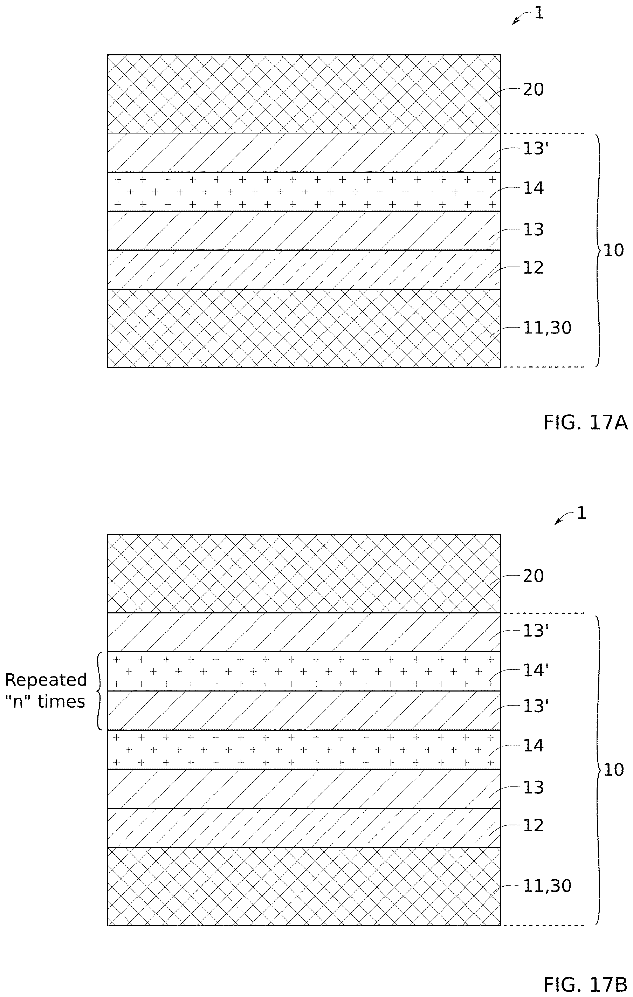

In order to increase the thickness along which the crystalline arrangement is propagated, and with references to Figure 17A, it is further possible to deposit a second undoped crystalline layer 14 over said Si-doped crystalline chalcogenide layer 13, and then deposit, on top of layer 14, a secondary Si-doped crystalline chalcogenide layer 13' based on the same material than the one of said Si-doped crystalline chalcogenide layer 13 and having the same concentration of Si dopants.

As illustrated on figure 17B, in order to further increase the thickness along which the crystalline arrangement is propagated, it is also possible to repeat *n* times depositions of pair(s) of secondary layers 13' and 14' on top of said second undoped crystalline layer 14, if needed before depositing a last secondary Si-doped crystalline chalcogenide layer 13' to form the top layer of the material stack 10. For instance, it is thus possible to repeat such deposits until a total thickness of 100 nm or more of the material stack 10 is reached.

Said second undoped crystalline layer 14 may have a thickness comprised in between 1 and 20 nm, in order to be textured in a same direction as the under-layer 12. Otherwise, said second undoped crystalline layer 14 is preferably based on a chalcogenide material. For instance, the chalcogenide material of the second undoped crystalline chalcogenide layer 14 may be different from, or the same than, the one of said Si-doped crystalline chalcogenide layer 13. This type of structure, shown on Figures 17A and 17B, will be called in the following multi-layer (or ML), in particular by opposition to the embodiment shown on figure 16.

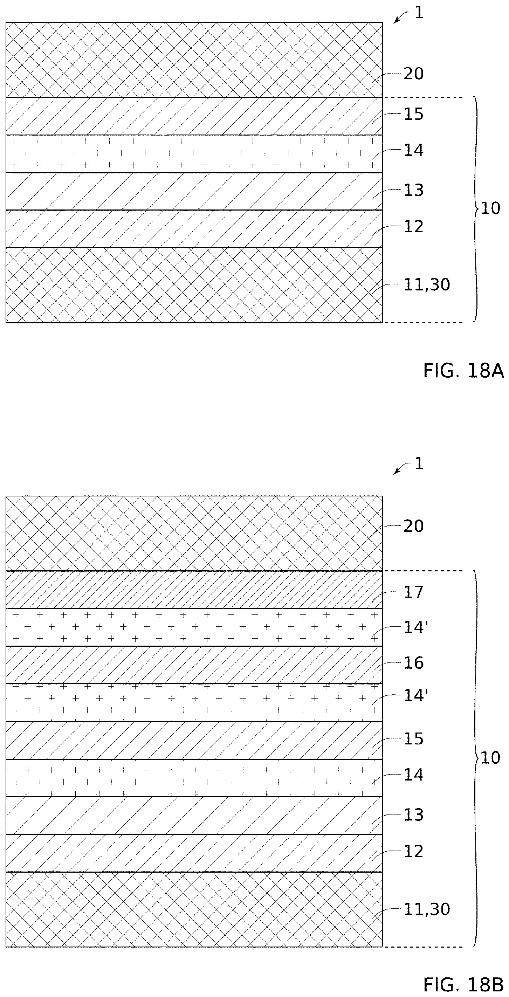

As an alternative to the bi-layer embodiment shown on figure 17A, and with references to Figure 18A, it is possible to deposit, on the second undoped crystalline layer 14, a secondary Si-doped crystalline chalcogenide layer 15 (instead of the one referred to by numeral reference 13 on figure 17A), with the chalcogenide material of the secondary Si-doped crystalline chalcogenide layer 15 being different from the one of said Si-doped crystalline chalcogenide layer 13 deposited on the UL 12 and/or having a different concentration of Si dopants than the one of said Si-doped crystalline chalcogenide layer 13.

As an alternative to the ML as shown on figure 17B, and with references to Figure 18B, it is further possible to alternate secondary undoped crystalline layers 14' (that could range, dependently on the chosen layer, from 1 nm up to 20 nm) and secondary Si-doped crystalline chalcogenide layer(s) 15, 16, 17, etc. (that could range, dependently on the chosen layer, from 0.5 nm up to 20 nm) for achieving a ML textured in a same direction as the under-layer 12 and with:
- the chalcogenide material of each of the secondary Si-doped crystalline chalcogenide layers 16, 17, etc. being different from, or the same than, the one of said secondary Si-doped crystalline chalcogenide layer 15 or said Si-doped crystalline chalcogenide layer 13 deposited on the UL 12, and/or
- at least one of the secondary Si-doped crystalline chalcogenide layers 16, 17, etc. having a concentration of Si dopants different:
   ∘ from each other, or
   ∘ from said secondary Si-doped crystalline chalcogenide layer 15, or
   ∘ from said Si-doped crystalline chalcogenide layer 13 deposited on the UL 12.

The higher the thickness of the undoped Si-doped crystalline chalcogenide layer(s) 14', etc., the higher is the control of the crystalline arrangement in the material stack 10 with larger total thickness (i.e. thickness along which the crystalline arrangement is propagated).

This possibility of growing a stack 10 as shown on Figure 16 or a multi-layer as shown on Figures 17A and 17B with crystalline arrangement has been demonstrated by the inventors in a cosputtering deposition chamber with a process temperature of 210°C, where the used under-layer 12 has a thickness of approximately 6 nm and was made of Sb₂Te₃ showing a crystalline orientation along the (001) planes.

More particularly, as per the embodiment shown on Figure 16, the growing of the under-layer 12 with crystalline arrangement has been done by cosputtering of Sb₂Te₃ and Te target(s) to obtain a sufficiently, or even perfectly, stoichiometric film, and the Si-doped crystalline chalcogenide layer 13 was based on either Sb₂Te₃ or Ge₂Sb₂Te₅ (GST) and obtained by the co-sputtering of the chalcogenide target with a Si target.

In order to enhance the crystalline arrangement of the Si-doped crystalline chalcogenide layers and of the undoped crystalline layers, we may deposit: firstly, the under-layer 12 on the substrate 11 and then we may alternate Ge₂Sb₂Te₅ and Sb₂Te₃, by doping with Si the first deposited one among these two chalcogenide materials.

The Si doping was obtained by the cosputtering of the stoichiometric chalcogenide material with a silicon target. The Si doping range may be modulated by changing the applied power on the silicon target. The single layer thickness may be varied from approximately 1 nm up to approximately 6 nm according to the studied structure.

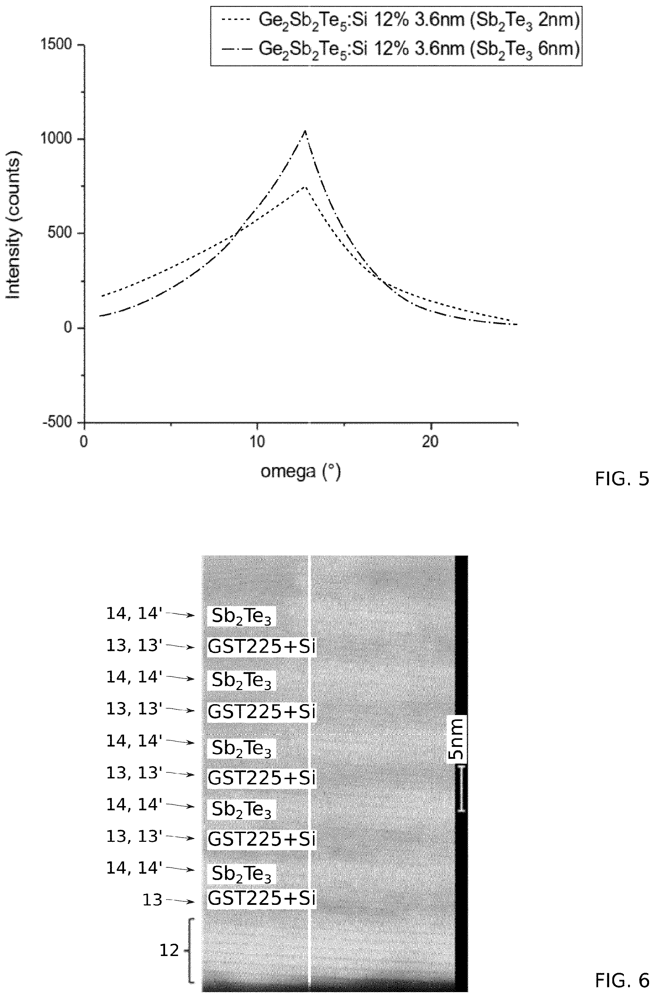

The demonstration of the possibility to obtain a textured ML doped with Si, is shown in the XRD (X-ray Powder Diffraction) spectra as illustrated on Figure 2, in which the ML without under-layer (curve with long dashes and dots) shows a poor crystallinity while the one with under-layer 12 (curve with dashes) shows very intense peaks: it certifies the high degree of crystallinity of the ML (i.e. crystalline arrangement is preserved despite the Si doping). The quality of the crystallinity was also confirmed by TEM images (See Fig. 6, 7 and 8).

The Si doping range that can allow obtaining textured materials is comprised in between 0.5 and 20 at. % of Si.

More particularly, in the above-mentioned experiment, the upper limit for a Si-doped chalcogenide layer 13 based on Ge₂Sb₂Te₅ is about 15 at. % of Si.

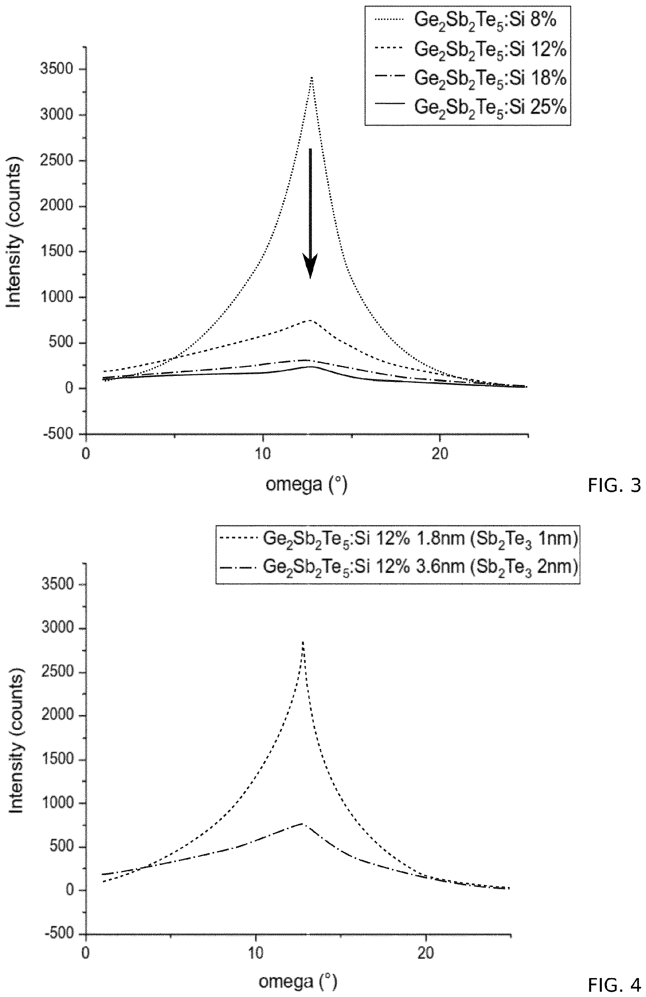

One way to investigate if the Si-doped chalcogenide layers are textured is the XRD measurement, and more particularly an omega scan at 2Theta angle position of the main peak (equal to 25.5°) for this kind of composition. Figure 3 shows the impact of the Si doping on such ML structure composed by an under-layer 12 of Sb₂Te₃ textured along the (00I) planes and alternating layers of Ge₂Sb₂Te₅ (doped with different at. % of Si) with a thickness of approximately 3.6 nm and Sb₂Te₃ (undoped) with a thickness of approximately 2.1 nm, and a total thickness of about 50 nm (total thickness of the deposited multilayer). We observe that the height of the peak decreases as the atomic percentage of Si dopants increases. This flattening of the omega scans, notably above 12 at. % of Si and below 18 at. % of Si, leads to the upper bound limit for the Si doping in this configuration at about 15 at. % of Si.

Figure 4 shows the impact of the thickness of the material stack 10 as illustrated on Figure 17A: if the Si-doped Ge₂Sb₂Te₅ layer 13 is thinner (for instance 1.8 nm instead of 3.6 nm), the crystalline arrangement degree is higher (the peak of the curve with dots of Figure 4 is more intense). The under-layer 12 and more generally at least one of the undoped layer(s) 12, 14, and 14' as illustrated on Figures 16, 17A, 17B, 18A and 18B has also an important role. For instance, if we increase the thickness(es) of at least one of the undoped layers 12, 14 and 14', still alternating it with the same Si-doped crystalline chalcogenide layer 13 (based for instance on Ge₂Sb₂Te₅), it will increase the global crystalline arrangement degree of the ML structure. This is illustrated by the graph of Figure 5 wherein the less intense peak (curve with dashes) has been obtained for a second undoped crystalline layer 14 of Sb₂Te₃ of a thickness equal to 2 nm and the more intense peak (curve with long dashes and dots) has been obtained for a second undoped crystalline layer 14 of Sb₂Te₃ of a thickness equal to 6 nm, both structures deposited on a under-layer 12 of Sb2Te3 equal to 6.3nm and a layer 13 of GST:Si of 3.6nm.

The TEM image of Figure 6 shows, for a multilayer made of undoped Sb₂Te₃ layers 14, 14' and Ge₂Sb₂Te₅:Si8% (i.e. Ge₂Sb₂Te₅ doped with 8 at. % of Si) layers 13, 13', how the multilayer is crystalline with high orientation over the total thickness of 50 nm of the multilayer.

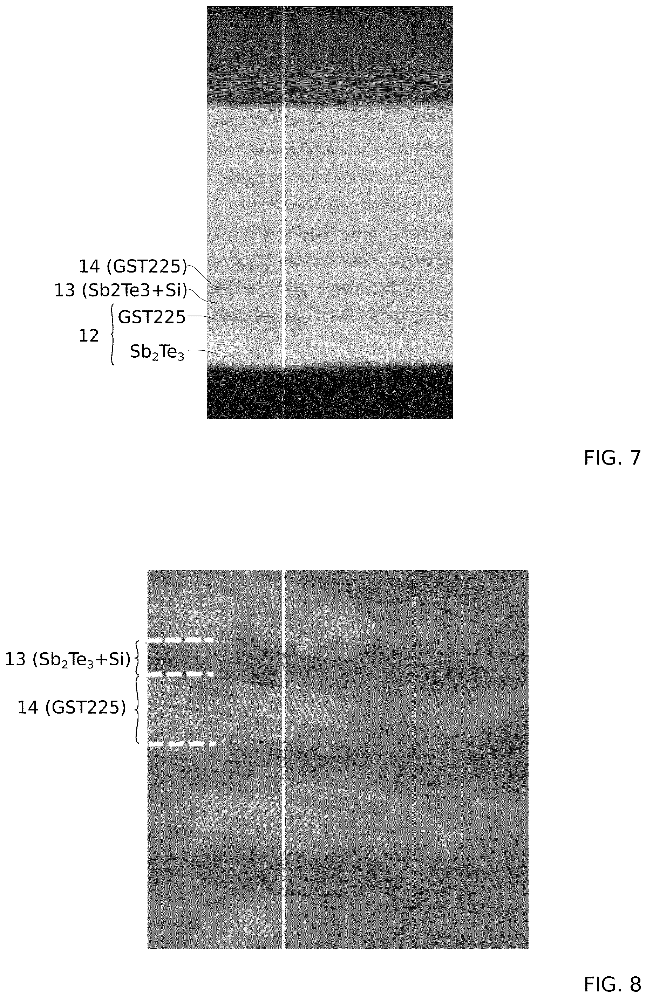

In the case of Sb₂Te₃ as based material for the Si-doped chalcogenide layer(s) 13, 13' the upper limit of Si doping is about 20 at. % of Si. The same proof than for GST can be provided. The TEM images of Figure 7 and Figure 8 show the highly textured as-deposited multilayer obtained by the alternated deposition of undoped Ge₂Sb₂Te₅ 14, 14' with a thickness of approximately 3.6 nm and Si-doped Sb₂Te₃:Si12% layer(s) 13, 13' with a thickness of approximately 2.1 nm on an under-layer layer 12 at least partially based on Sb₂Te₃. In this particular case, the second undoped crystalline layer 14 is deposited before the Si-doped chalcogenide layer 13, but it maintains the same crystalline orientation as the UL 12. This configuration represents a possible variant of the stacking. Otherwise, the example shown on Figure 7, which is outside the scope of the present invention, allows illustrating that the UL 12 is not necessarily made of a single layer but can also take the form of a multilayer. Indeed, according to the example shown on figure 7, the underlayer is a bilayer made of a first layer based on Sb₂Te₃ extending on the substrate 11 and of a second layer based on Ge₂Sb₂Te₅ extending on the first layer. It should be noted that, in the case of an under-layer 12 taking the form of a bilayer, the second layer is preferably of a thickness less than or equal to half the thickness of the underlying layer.

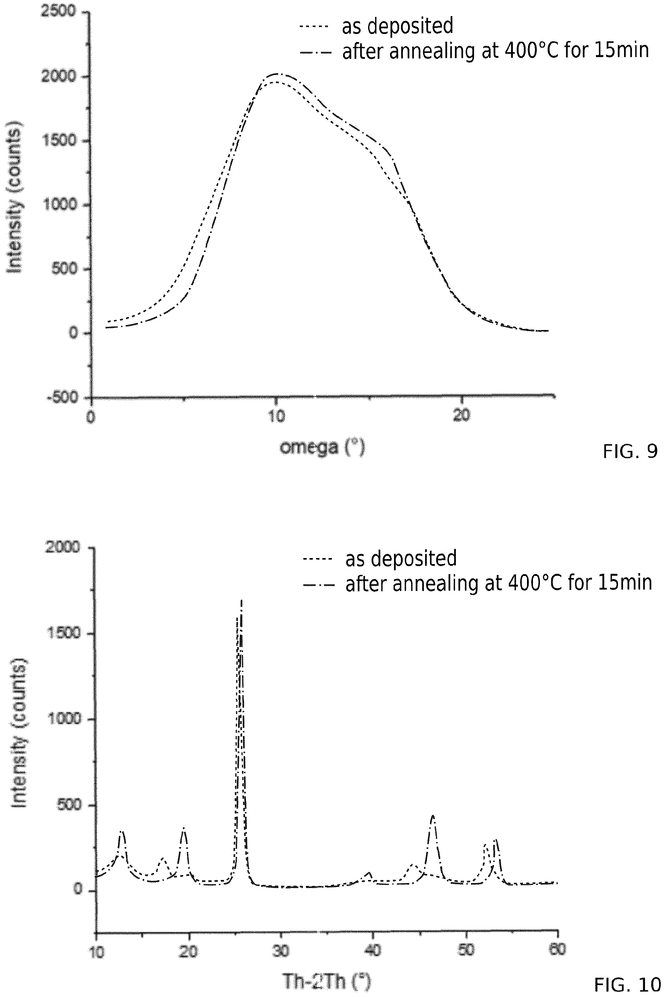

From inventor's experience, further thermally treating the multilayer at 400°C for 15 minutes, thus achieving a thermally processed material stack according to the second aspect, does not degrade the crystalline arrangement as can be seen by the XRD omega scan shown on Figure 9 of a multilayer with Si-doped Sb₂Te₃:Si12% layer(s) 13, 13' with a thickness of approximately 2.1 nm and undoped Ge₂Sb₂Te₅ layers 14, 14' with a thickness of approximately 3.6 nm over an under-layer 12 of Sb₂Te₃ with a thickness of approximately 6.3 nm; indeed, where the curve with dashes is obtained by XRD omega scan of the material stack 10 as deposited, that is before any thermal treatment, and the curve with long dashes and dots is obtained by XRD omega scan of the material stack 10 after thermal treatment, the curves are not significantly different from each other.

The XRD 2Theta-Theta scan as illustrated on Figure 10 shows how the material stack 10 rearranges: this phenomenon induces the enhancement and the shift of certain XRD peaks.

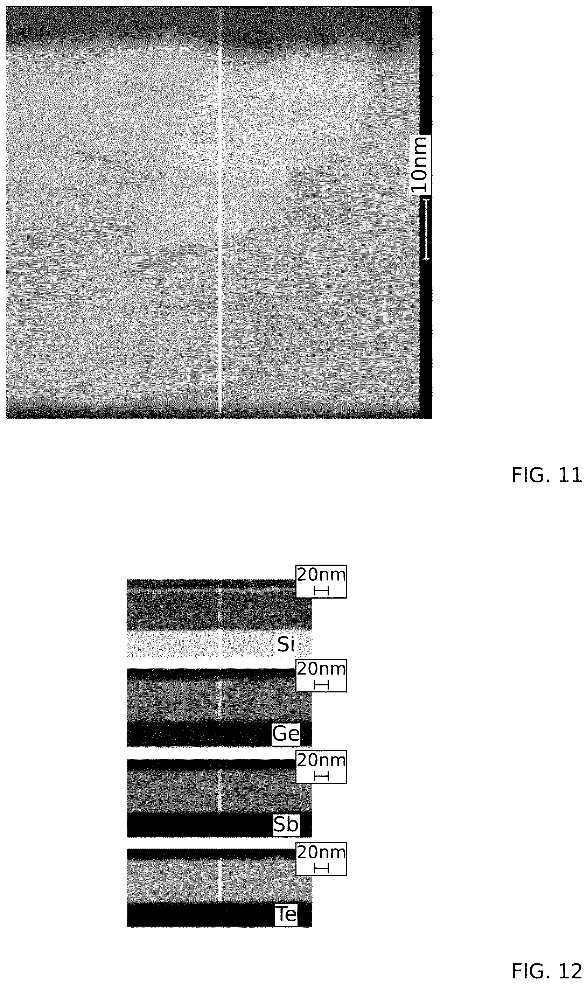

In the TEM image of Figure 11, it can be noticed that the multilayer keeps the crystalline arrangement along the z direction, and we can recognize the alternation of atomic blocks separated by Van Der Waals (VdW) gaps.

As illustrated on Figure 12, the EDX images of the material stack 10 after thermal treatment, that is the EDX images of the thermally processed material stack according to the second aspect of the invention, show that the composition of the thermally treated stack is uniform along its thickness losing the multi-layer structure. Also, the silicon is uniformly distributed, without the appearing of any precipitation, which means that the Si dopants accommodate in the crystalline chalcogenide layers 13, 13', 14, and 14'.

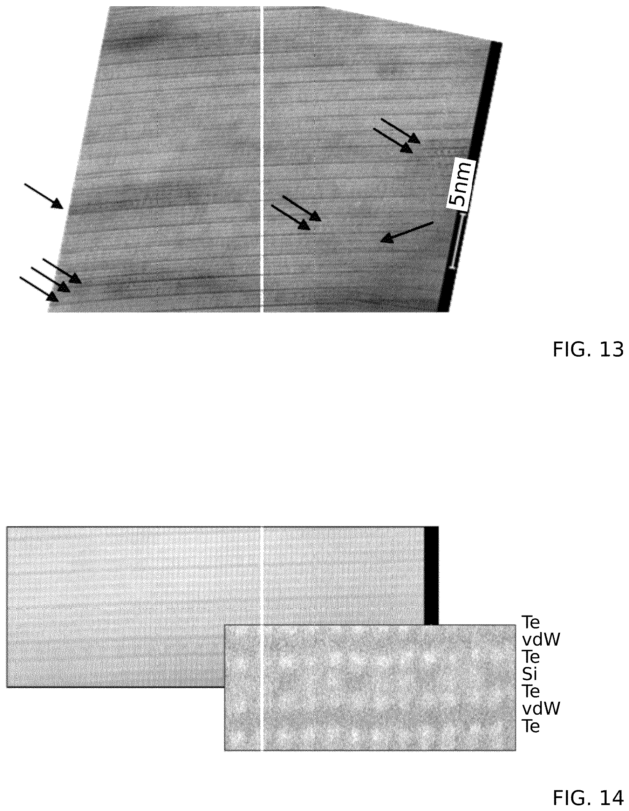

It was also noticed that the doping of Ge₂Sb₂Te₅ material with 8 at. % of Si for manufacturing the Si-doped crystalline chalcogenide layer(s) 13, 13', gives rise to the appearing of a new feature as shown for instance on Figures 13 and 14. The TEM images illustrated on Figures 13 and 14 show the presence of new atomic arrangement with 3-tuple which is not characteristics of any GeₓSb_{y}Te_{z} crystalline block. This new feature can probably be induced by the creation of Si-Te bonds and so the arrangement of Si atoms between Te planes, confirming the perfect incorporation of Si in the crystalline structure of the Si-doped chalcogenide layer(s) 13, 13'.

As a comparison with respect to what previously shown, in Figure 15 is shown the TEM image of a GST124 layer doped with Si deposited on a SiN substrate 11, without under-layer and after annealing at 400°C. The GST124 layer does not show any crystalline arrangement (not even in a direction different from the z one), but only a polycrystalline structure.

The invention is not limited to the embodiments previously described and extends to all the embodiments covered by the claims.

## Claims

1. A material stack (10) for a microelectronic device (1) comprising
a. a substrate (11),
b. a first undoped monocrystalline layer (12) on the substrate, said first undoped monocrystalline layer having a thickness superior or equal to 4 nm, and
c. a Si-doped crystalline chalcogenide layer (13) on the first undoped monocrystalline layer, said Si-doped crystalline chalcogenide layer being doped with Si having an atomic concentration ranging from 0.5 at.% to 20 at.%, and preferably from 2 at.% to 12 at.%, and said Si-doped crystalline chalcogenide layer (13) having a thickness comprised in between 0.5 nm and 20 nm.

2. The material stack (10) according to the preceding claim, wherein the first undoped monocrystalline layer (12) is based on a material allowing its heterogenous epitaxial growth on the substrate (11) and allowing the heterogenous epitaxial growth of the Si-doped crystalline chalcogenide layer (13) thereon.

3. The material stack (10) according to any one of the preceding claims, wherein said first undoped monocrystalline layer (12) is an undoped monocrystalline chalcogenide layer.

4. The material stack (10) according to any one of the preceding claims, wherein the Si-doped chalcogenide layer (13) is monocrystalline.

5. The material stack (10) according to any one of the preceding claims, wherein the first undoped monocrystalline layer (12) is monocrystalline as deposited on the substrate, and wherein the Si-doped chalcogenide layer (13) is crystalline as deposited on the first undoped monocrystalline layer.

6. The material stack (10) according to any one of the preceding claims, further comprising:
a. a second undoped crystalline layer (14) over said Si-doped crystalline chalcogenide layer (13), with said second undoped crystalline layer (14) having a thickness comprised in between 1 and 20 nm and being preferably based on a chalcogenide material, and
b. a secondary Si-doped crystalline chalcogenide layer (13') over said second undoped crystalline layer (14), with said secondary Si-doped crystalline chalcogenide layer (13') being based on the same chalcogenide material as said Si-doped crystalline chalcogenide layer (13).

7. The material stack (10) according to any one of claims 1 to 5, further comprising:
a. a second undoped crystalline layer (14) over said Si-doped crystalline chalcogenide layer (13), with said second undoped crystalline layer (14) having a thickness comprised in between 1 and 20 nm and being preferably based on a chalcogenide material, and
b. a secondary Si-doped crystalline chalcogenide layer (15) over said second undoped crystalline layer (14), with said secondary Si-doped crystalline chalcogenide layer (15) being based on a different chalcogenide material than the one of said Si-doped crystalline chalcogenide layer (13) and/or having a different concentration of Si dopants than the one of said Si-doped crystalline chalcogenide layer (13).

8. The material stack (10) according to any one of the preceding claims, wherein the substrate (11) comprises a heater, and wherein the first undoped monocrystalline layer (12) is over the heater.

9. The material stack (10) according to any one of the preceding claims, wherein each Si-doped crystalline chalcogenide layer (13, 13', 15, 16, 17) and/or each undoped crystalline chalcogenide layer (14, 14') is based on a material chosen among:
a. GeₓSb_{y}Te_{z}, GST, where "x-y-z" are chosen to reach a stoichiometric composition allowing a deviation of plus or minus 2 at. %, preferably 1 at. %, from a targeted stoichiometric composition,
b. GeTe, and
c. Sb₂Te₃.

10. The material stack (10) according to any one of the preceding claims, wherein the first undoped monocrystalline layer (12) extending on the substrate (11) is based on at least one material chosen from:
a. Sb₂Te₃,
b. Bi₂Te₃, and
c. Sb₂Se₃.

11. A method for manufacturing a thermally processed material stack comprising:
a. a step of providing a material stack (10) according to any one of claims 1 to 10; and
b. a step of thermal treatment of the provided material stack.

12. The method according to the preceding claim, wherein said step of thermal treatment is part of an integration process of the material stack (10) in a microelectronic device (1).

13. The method according to any one of the two preceding claims, wherein the Si-doped crystalline chalcogenide layer is formed by co-sputtering deposition.

14. A microelectronic device (1), such as a Phase-Change Memory, PCM, device, comprising at least a material stack (10) according to any one of claims 1 to 10 or at least a thermally processed material stack manufactured according to the method of claim 11, further comprising a top electrode (20) of the microelectronic device (1) on the material stack, and wherein the substrate (11) of the concerned material stack comprises a bottom electrode (30) of the microelectronic device (1).

## Patentansprüche

1. Materialstapel (10) für eine mikroelektronische Vorrichtung (1), umfassend
a. ein Substrat (11),
b. eine erste undotierte monokristalline Schicht (12) auf dem Substrat, wobei die erste undotierte modulkristalline Schicht eine Dicke größer oder gleich 4 nm aufweist, und
c. eine Si-dotierte kristalline Chalkogenidschicht (13) auf der ersten undotierten monokristallinen Schicht, wobei die Si-dotierte monokristalline Chalkogenidschicht mit Si dotiert ist, das eine Atomkonzentrationen von 0,5 At.-% bis 20 At.-% und bevorzugt von 2 At.-% bis 12 At.-% aufweist, und die Si-dotierte kristalline Chalkogenidschicht (13) eine Dicke zwischen 0,5 und 20 nm aufweist.

2. Materialstapel (10) nach dem vorstehenden Anspruch, wobei die erste undotierte monokristalline Schicht (12) auf einem Material basiert, das ihr heterogenes epitaktisches Wachstum auf dem Substrat (11) erlaubt und das heterogener epitaktische Wachstum der Si-dotierten kristallinen Chalcogenidschicht (13) darauf erlaubt.

3. Materialstapel (10) nach einem der vorstehenden Ansprüche, wobei
die erste undotierte monokristalline Schicht (12) eine undotierte monokristalline Chalcogenidschicht ist.

4. Materialstapel (10) nach einem der vorstehenden Ansprüche, wobei
die Si-dotierte Chalcogenidschicht (13) monokristallin ist.

5. Materialstapel (10) nach einem der vorstehenden Ansprüche, wobei
die erste undotierte monokristalline Schicht (12), wie sie auf dem Substrat aufgebracht ist, monokristallin ist, und wobei die Si-dotierte Chalcogenidschicht (13), wie sie auf der ersten undotierten monokristallen Schicht aufgebracht ist, kristallin ist.

6. Materialstapel (10) nach einem der vorstehenden Ansprüche, der weiter Folgendes umfasst:
a. eine zweite undotierte kristalline Schicht (14) über der Si-dotierten kristallinen Chalcogenidschicht (13), wobei die zweite undotierte kristalline Schicht (14) eine Dicke zwischen 1 und 20 nm aufweist und bevorzugt auf einem Chalcogenidmaterial basiert, und
b. eine sekundäre Si-dotierte kristalline Chalcogenidschicht (13') über der zweiten undotierten kristallinen Schicht (14), wobei die sekundäre Si-dotierte kristalline Chalcogenidschicht (13') auf demselben Chalcogenidmaterial basiert wie die Si-dotierte kristalline Chalcogenidschicht (13).

7. Materialstapel (10) nach einem der Ansprüche 1 bis 5, der ferner Folgendes umfasst:
a. eine zweite undotierte kristalline Schicht (14) über der Si-dotierten kristallinen Chalcogenidschicht (13), wobei die zweite undotierte kristalline Schicht (14) eine Dicke zwischen 1 und 20 nm aufweist und bevorzugt auf einem Chalcogenidmaterial basiert, und
b. eine sekundäre Si-dotierte kristalline Chalcogenidschicht (15) über der zweiten undotierten kristallinen Schicht (14), wobei die zweite sekundäre Si-dotierte kristalline Chalcogenidschicht (15) auf einem Chalcogenidmaterial basiert, das sich von dem auf der Si-dotierten kristallinen Chalcogenidschicht (13) unterscheidet und/oder eine Konzentration an Si-Dotierstoffen aufweist, die sich von der einen der Si-dotierten kristallinen Chalcogenidschicht (13) unterscheidet.

8. Materialstapel (10) nach einem der vorstehenden Ansprüche, wobei
das Substrat (11) eine Heizvorrichtung umfasst, und wobei sich die erste undotierte monokristalline Schicht (12) über der Heizvorrichtung befindet.

9. Materialstapel (10) nach einem der vorstehenden Ansprüche, wobei
jede Si-dotierte kristalline Chalcogenidschicht (13, 13', 15, 16, 17) und/oder jede undotierte kristalline Chalcogenidschicht (14, 14') auf einem Material basiert, das ausgewählt ist aus:
a. GeₓSb_{y}Te_{z}, GST,
wobei "x-y-z" ausgewählt sind, um eine stöchiometrische Zusammensetzung zu erreichen, die eine Abweichung von plus oder minus 2 At.-%, bevorzugt 1 At.-% von einer stöchiometrischen Zielkomposition erlaubt,
b. GeTe, and
c. Sb₂Te₃.

10. Materialstapel (10) nach einem der vorstehenden Ansprüche, wobei sich die erste undotierte monokristalline Schicht (12), die auf dem Substrat (11) erstreckt, auf mindestens einem Material basiert, das ausgewählt ist aus:
a. Sb₂Te₃,
b. Bi₂Te₃, und
c. Sb₂Se₃.

11. Verfahren zur Herstellung eines thermisch verarbeiteten Materialstapels, umfassend:
a. einen Schritt zum Bereitstellen eines Materialstapels (10) nach einem der Ansprüche 1 bis 10; und
b. einen Wärmebehandlungsschritt des bereitgestellten Materialstapels.

12. Verfahren nach dem vorstehenden Anspruch, wobei der Wärmebehandlungsschritt Teil eines Integrationsprozesses des Materialstapels (10) in eine mikroelektronische Vorrichtung (1) ist.

13. Verfahren nach einem der beiden vorstehenden Ansprüche, wobei die Si-dotierte kristalline Chalcogenidschicht durch Co-Sputter-Abscheidung gebildet wird.

14. Mikroelektronische Vorrichtung (1) wie eine Phasenwechselspeichervorrichtung, PCM-Vorrichtung,
die mindestens einen Materialstapel (10) nach einem der Ansprüche 1 bis 10 oder mindestens einen thermisch verarbeiteten Materialstapel, der gemäß dem Verfahren nach Anspruch 11 hergestellt ist, umfasst,
die ferner eine obere Elektrode (20) der mikroelektronischen Vorrichtung (1) auf dem Materialstapel umfasst, und wobei das Substrat (11) des betroffenen Materialstapels eine untere Elektrode (30) der mikroelektronischen Vorrichtung (1) umfasst.

## Revendications

1. Empilement de matériaux (10) pour un dispositif microélectronique (1) comprenant :
a. un substrat (11),
b. une première couche monocristalline non dopée (12) sur le substrat, ladite première couche monocristalline non dopée ayant une épaisseur supérieure ou égale à 4 nm, et
c. une couche de chalcogénure cristallin dopé au Si (13) sur la première couche monocristalline non dopée, ladite couche de chalcogénure cristallin dopée au Si étant dopée avec du Si ayant une concentration atomique allant de 0,5 % at. à 20 % at., et de préférence de 2 % at. à 12 % at., et ladite couche de chalcogénure cristallin dopée au Si (13) ayant une épaisseur comprise entre 0,5 nm et 20 nm.

2. Empilement de matériaux (10) selon la revendication précédente, dans lequel la première couche monocristalline non dopée (12) est basée sur un matériau permettant sa croissance épitaxiale hétérogène sur le substrat (11) et permettant la croissance épitaxiale hétérogène de la couche de chalcogénure cristallin dopée au Si (13) sur celui-ci.

3. Empilement de matériaux (10) selon l'une quelconque des revendications précédentes, dans lequel
ladite première couche monocristalline non dopée (12) est une couche de chalcogénure monocristallin non dopée.

4. Empilement de matériaux (10) selon l'une quelconque des revendications précédentes, dans lequel
la couche de chalcogénure dopée au Si (13) est monocristalline.

5. Empilement de matériaux (10) selon l'une quelconque des revendications précédentes, dans lequel la première couche monocristalline non dopée (12) est monocristalline lorsqu'elle est déposée sur le substrat, et dans lequel
la couche de chalcogénure dopée au Si (13) est cristalline lorsqu'elle est déposée sur la première couche monocristalline non dopée.

6. Empilement de matériaux (10) selon l'une quelconque des revendications précédentes, comprenant en outre :
a. une deuxième couche cristalline non dopée (14) sur ladite couche de chalcogénure cristallin dopée au Si (13), ladite deuxième couche cristalline non dopée (14) ayant une épaisseur comprise entre 1 et 20 nm et étant de préférence basée sur un matériau de chalcogénure, et
b. une couche secondaire de chalcogénure cristallin dopée au Si (13') sur ladite deuxième couche cristalline non dopée (14), ladite couche secondaire de chalcogénure cristallin dopée au Si (13') étant basée sur le même matériau de chalcogénure que ladite couche de chalcogénure cristallin dopée au Si (13).

7. Empilement de matériaux (10) selon l'une quelconque des revendications 1 à 5, comprenant en outre :
a. une seconde couche cristalline non dopée (14) sur ladite couche de chalcogénure cristallin dopée au Si (13), ladite seconde couche cristalline non dopée (14) ayant une épaisseur comprise entre 1 et 20 nm et étant de préférence basée sur un matériau de chalcogénure, et
b. une couche secondaire de chalcogénure cristallin dopée au Si (15) sur ladite seconde couche cristalline non dopée (14), ladite couche secondaire de chalcogénure cristallin dopée au Si (15) étant basée sur un matériau de chalcogénure différent de celui de ladite couche de chalcogénure cristallin dopée au Si (13) et/ou ayant une concentration de dopants au Si différente de celle de ladite couche de chalcogénure cristallin dopée au Si (13).

8. Empilement de matériaux (10) selon l'une quelconque des revendications précédentes, dans lequel le substrat (11) comprend un élément chauffant, et dans lequel
la première couche monocristalline non dopée (12) est au-dessus de l'élément chauffant.

9. Empilement de matériaux (10) selon l'une quelconque des revendications précédentes, dans lequel
chaque couche de chalcogénure cristallin dopée au Si (13, 13', 15, 16, 17) et/ou chaque couche de chalcogénure cristallin non dopée (14, 14') est basée sur un matériau choisi parmi :
a. GexSbyTez, GST,
où « x-y-z » sont choisis pour atteindre une composition stœchiométrique permettant un écart de plus ou moins 2 % at., de préférence 1 % at., par rapport à une composition stœchiométrique ciblée,
b. GeTe et
c. Sb2Te3.

10. Empilement de matériaux (10) selon l'une quelconque des revendications précédentes, dans lequel la première couche monocristalline non dopée (12) s'étendant sur le substrat (11) est basée sur au moins un matériau choisi parmi :
a. Sb2Te3,
b. Bi2Te3 et
c. Sb2Se3.

11. Procédé de fabrication d'un empilement de matériaux traité thermiquement comprenant :
a. une étape de fourniture d'un empilement de matériaux (10) selon l'une quelconque des revendications 1 à 10 ; et
b. une étape de traitement thermique de l'empilement de matériaux fourni.

12. Procédé selon la revendication précédente, dans lequel ladite étape de traitement thermique fait partie d'un processus d'intégration de l'empilement de matériaux (10) dans un dispositif microélectronique (1).

13. Procédé selon l'une quelconque des deux revendications précédentes, dans lequel la couche de chalcogénure cristallin dopée au Si est formée par dépôt par co-pulvérisation cathodique.

14. Dispositif microélectronique (1), tel qu'un dispositif de mémoire à changement de phase, PCM,
comprenant au moins un empilement de matériaux (10) selon l'une quelconque des revendications 1 à 10 ou au moins un empilement de matériaux traité thermiquement fabriqué selon le procédé de la revendication 11,
comprenant en outre une électrode supérieure (20) du dispositif microélectronique (1) sur l'empilement de matériaux, et dans lequel le substrat (11) de l'empilement de matériaux concerné comprend une électrode inférieure (30) du dispositif microélectronique (1).
